# EUROPÄISCHE PATENTSCHRIFT

(11) **EP 3 929 969 B1**
(45) Veröffentlichungstag und Bekanntmachung des Hinweises auf die Patenterteilung: **06.12.2023**
(21) Anmeldenummer: 20181299.7
(22) Anmeldetag: 22.06.2020
(51) Int. Cl.: H01L 21/673

(54) **VERFAHREN ZUM HERSTELLEN EINES PROZESSBEHÄLTERS FÜR HALBLEITERWERKSTÜCKE UND PROZESSBEHÄLTER**
METHOD FOR MANUFACTURING A PROCESS CONTAINER FOR SEMICONDUCTOR WORKPIECES AND PROCESS CONTAINER
PROCÉDÉ DE FABRICATION D'UNE CUVE DE TRAITEMENT POUR PIÈCES À SEMICONDUCTEUR ET CUVE DE TRAITEMENT

(43) Veröffentlichungstag der Anmeldung: 29.12.2021
(73) Patentinhaber: Siltronic AG, 81677 München (DE)
(72) Erfinder: Lamprecht, Ludwig, 83376 Truchtlaching (DE); Franke, Jonny, 09575 Eppendorf (DE); Vogel, Thoralf, 09514 Lengefeld (DE)

(56) Entgegenhaltungen:
- WO-A1-2004/005163
- DE-A1- 4 223 326
- DE-A1-102004 019 664
- US-A1- 2004 206 663
- US-A1- 2005 236 110
- US-A1- 2009 200 250
- US-A1- 2017 294 327

## Beschreibung

### Stand der Technik

Bei der Herstellung und Bearbeitung von Halbleiterwerkstücken wie z.B. Scheiben (oder Wafer) aus Silizium oder anderen Halbleitermaterialien werden sog. Prozessbehälter verwendet, um diese Halbleiterwerkstücke transportieren und/oder in bestimmter Ausrichtung halten zu können, zugleich aber auch die Halbleiterwerkstücke, wenn sie sich in dem Prozessbehälter befinden, bearbeiten, z.B. ätzen und/oder reinigen, zu können.

Solche Prozessbehälter für Halbleiterwerkstücke können als tiefgezogene oder geschweißte Behälter angefertigt werden. Durch diese Fertigungsverfahren sind, wie sich gezeigt hat, Formgebung und Funktionsmerkmale der Behälter allerdings nur eingeschränkt realisierbar.

Behältnisse für Halbleitersubstrate aus dem Stand der Technik sind in den folgenden Dokumenten beschrieben: US2004/0206663-A1, WO2004/005163-A1, US2005/02361 10-A1, DE4223326-A1.

Es besteht daher Bedarf an verbesserten Prozessbehältern für Halbleiterwerkstücke bzw. deren Herstellung.

### Offenbarung der Erfindung

Erfindungsgemäß werden ein Verfahren zum Herstellen eines Prozessbehälters für Halbleiterwerkstücke sowie ein solcher Prozessbehälter mit den Merkmalen der unabhängigen Patentansprüche vorgeschlagen. Vorteilhafte Ausgestaltungen sind Gegenstand der Unteransprüche sowie der nachfolgenden Beschreibung.

Die Erfindung beschäftigt sich mit der Herstellung eines Prozessbehälters für Halbleiterwerkstücke wie z.B. Siliziumwafer. Dabei wird aus einem Grundmaterial mittels eines additiven Aufbau- bzw. Herstellungsverfahrens - hierbei kann es sich insbesondere um einen sog. 3-D-Druck handeln - ein Behälter mit einer vorgegebenen Form erzeugt. Es wird also z.B. das Grundmaterial Schicht für Schicht aufeinander gefügt, bis letztlich die gewünschte, vorgegebene Form entstanden ist. Anschließend wird zumindest in vorbestimmten Bereichen einer Oberfläche des (auf diese Weise aufgebauten) Behälters ein Beschichtungsmaterial zum Schutz gegen Chemikalien aufgebracht, d.h. der Behälter wird mittels einer Beschichtung (die als Schutzschicht dient) chemikalienbeständig gemacht. Bei dem beschichteten Behälter kann dann von dem Prozessbehälter gesprochen werden. Die hierbei relevanten Bereiche der Oberfläche, auf die das Beschichtungsmaterial aufgebracht wird, sind insbesondere solche Bereiche, die später bei der Verwendung mit entsprechenden Medien oder Chemikalien in Berührung kommen und daher geschützt werden sollten. Dies betrifft insbesondere eine Innenseite des - typischerweise oben offenen - Behälters.

Mittels eines additiven Aufbauverfahrens bzw. mittels 3-D-Druck lassen sich gegenüber konventionellen Herstellungsverfahren in vielerlei Hinsicht optimierte Prozessbehälter für z.B. Transporte, Ätz- und Reinigungsprozesse für die Halbleiterindustrie anfertigen. Dies ist insbesondere aufgrund frei gestaltbarer Formgebung inkl. integrierter mechanischer Konstruktionselemente als Teil des auf diese Weise hergestellten Behälters möglich, und zwar ohne Zusatzkomponenten, die nachträglich mit den herkömmlich hergestellten Behältern verbunden werden müssen. Zusätzlich sind chemische Beständigkeit, Oberflächenbeschaffenheit und fluidtechnische Funktionsmerkmale für die jeweiligen Anwendungen gegenüber den herkömmlichen Herstellverfahren variabler und angepasster wählbar, wie nachfolgend noch näher erläutert wird.

Eine verbesserte oder gar optimierte Chemikalienbeständigkeit wird durch das Aufbringen des Beschichtungsmaterials, die als Oberflächenversiegelung dient bzw. eine solche bewirkt, erreicht. Bevorzugte Beschichtungsmaterialien sind dabei Polytetrafluorethylen, PTFE, Perfluoralkoxy-Polymer, PFA, sowie Polyvinylidenfluorid, PVDF.

Mittels eines additiven Aufbauverfahrens wie 3-D-Druck hergestellte Komponenten wie auch der erwähnte Behälter (nur) aus dem Grundmaterial kann als Prozessbehälter in der Regel nicht verwendet werden, da die Rauheit der Oberflächen zu stark ausgeprägt ist, d.h. die Oberflächen weisen in der Regel eine zu starke Rauheit für die gewünschte Verwendung auf. Dadurch lagern sich organische und anorganische Verschmutzungen an den Oberflächen ein und an und beeinflussen die Qualität der zu bearbeitenden Halbleiterwerkstücke negativ. Durch die Beschichtung mit z.B. PTFE auf den relevanten Oberflächen eines mittels eines additiven Aufbauverfahrens hergestellten Behälters ist es nunmehr jedoch möglich, die positiven Eigenschaften eines auf herkömmliche Art hergestellten Prozessbehälters (also insbesondere die Chemikalienbeständigkeit) mit den positiven Eigenschaften eines mittels eines additiven Aufbauverfahrens hergestellten Behälters für Silizium-Wafer (also insbesondere die freie Formgebung) zu verbinden.

Da ein mittels eines additiven Aufbauverfahrens hergestellter Behälter bei herkömmlichen Beschichtungsverfahren thermisch stark belastet wird und sich dadurch verformen würde, wurde im Rahmen der Erfindung gezielt ein Niedertemperatur-Beschichtungsverfahren in Kombination mit dem additiven Aufbauverfahren entwickelt. Herkömmlicherweise werden die für die Prozesse bei Halbleiterwerkstücken erforderlichen High-Purity-Beschichtungen (also Beschichtungen von besonders hoher Reinheit) bei hohen Temperaturen auf Oberflächen aufgebracht.

Durch ein gezielt eingesetztes Niedertemperatur-Beschichtungsverfahren, bevorzugt mit einer Temperatur unterhalb von 150°C, lassen sich High-Purity-Beschichtungen auch auf die weniger temperaturstabilen Oberflächen von z.B. 3-D- gedruckten Behältern aufbringen und somit die Vorteile wie freie Formgebung, gezielte Zu- bzw. Abführung der Chemikalien in den Prozessbehälter und die chemischen und physikalischen Eigenschaften zusammenführen. Beispielsweise weist das Material PA 3200GF eine Formbeständigkeitstemperatur (bei einem Druck von 0,45 MPa und in X-Richtung) von max. 157°C nach ISO 75-1/-2 auf. Vergleichbares gilt für die bevorzugten Grundmaterialien, die ein Polyamid, insbesondere gefüllt mit Glaskugeln, aufweisen. Wird diese Temperatur überschritten, fällt die plastische Kontur typischerweise in sich zusammen. PTFE-Beschichtungen z.B. werden in der Regel aufgespritzt und in einem Ofen bei einer Temperatur von etwa 220°C bis 420°C gesintert. Durch ein Nieder-Temperatur-Sinterverfahren, das sich typischerweise über einen längeren Zeitraum bei z.B. 100°C erstreckt, konnte erreicht werden, einen 3-D-gedruckten Behälter für Silizium-Wafer chemie- und schmutzresistent zu machen.

Eine Oberflächenrauigkeit der mittels eines additiven Aufbauverfahrens hergestellten Behälter lässt sich durch Niedertemperatur-Beschichtungen reduzieren - typischerweise lassen sich die Rz- und Ra-Werte (die die Rauheit spezifizieren) um ca. 70 % gegenüber den entsprechenden Werten des Behälters ohne die Niedertemperatur-Beschichtung reduzieren. Dies trägt damit auch dazu bei, dass Partikel oder andere organische oder anorganische Bestandteile der Flüssigkeiten im Prozessbehälter deutlich weniger an den Oberflächen (des Behälters) anhaften und dadurch deutlich leichter und gezielt entfernt werden können, wenn die Flüssigkeit z.B. gewechselt werden soll.

Das vorgeschlagene additive Aufbauverfahren erlaubt optimierte Behälterausführungen, d.h. hinsichtlich der Form optimierte Prozessbehälter. So ist damit z.B. ein prozessoptimiertes Flüssigkeitsvolumen des Prozessbehälters durch die fertigungstechnisch leicht anpassbare Form des Behälters an die darin transportierten oder prozessierten Halbleiterwerkstücke möglich, sodass bei Verwendung des Prozessbehälters keine unnötig hohen Mengen an Medium oder Chemikalien benötigt werden (d.h. das Volumen, in dem Flüssigkeit aufgenommen wird, ist z.B. so gering wie möglich gehalten).

Besonders bevorzugt weist die vorgegebene Form des Behälters eine Zu- und/oder eine Abführung für Medien oder Chemikalien auf, denkbar sind auch mehrere Zu- und/oder Abführungen. Zweckmäßig sind auch eine oder mehrere integrierte Werkstückaufnahmen für eines oder mehrere Halbleiterwerkstücke oder Träger hierfür. Eine Werkstückaufnahme kann z.B. derart gestaltet sein, dass darin direkt ein oder mehrere Halbleiterwerkstücke eingebracht und gehalten werden können. Ebenso kann eine Werkstückaufnahme aber z.B. auch derart gestaltet sein, dass darin ein Träger, eine Kassette oder andere Halterung eingebracht werden kann, in der dann wiederum eines oder bevorzugt mehrere Halbleiterwerkstücke eingebracht und gehalten werden können (es kann z.B. in eine Werkstückaufnahme eine Kassette für fünf oder zehn Siliziumwafer eingebracht werden, sodass diese fünf oder zehn Siliziumwafer zusammen eingebracht bzw. entnommen werden können). Zudem sind einer oder mehrere Rahmen und/oder eine oder mehrere Befestigungseinrichtungen zur Anbringung an einer Prozessanlage bevorzugt, ebenso sind in die Behälterform integrierte Versteifungen denkbar.

Solche Zu- bzw. Abführungen können insbesondere in die Form integriert werden und sind dabei beliebig gestaltbar. Bei herkömmlich angefertigten Prozessbehältern werden Zu- bzw. Abführungen typischerweise mittels zusätzlicher Rohrleitungen inkl. Befestigungen der Rohrleitungen an dem Behälter realisiert. Das additive Aufbauverfahren bzw. der 3-D-Druck ermöglicht demgegenüber die Integration solcher Zu- bzw. Abführungen in die Behälterform, z. B. in seitlichen Wänden oder den Boden und die gezielte Anordnung der Ein- bzw. Austrittsöffnung an solchen Stellen, die für eine schnelle und räumlich nahe Zuführung der Prozessmedien, z.B. konzentrierte Ätzlösungen, ideal sind. Dies kann dabei auch je nach gewünschter Verwendung des Prozessbehälters bzw. des Prozesses bzw. der Prozesse, wofür er verwendet werden soll, gezielt gestaltet werden.

In Prozessbehältern werden oftmals mehrere Wafer oder andere Halbleiterwerkstücke gleichzeitig in das Prozessmedium bzw. die Prozessflüssigkeit innerhalb des Prozessbehälters abgestellt. Typischerweise werden Prozessmedien durch Zirkulation zwischen die Wafer eingeleitet und Rückstände, z.B. Partikel, gerichtet abgeführt. Die Herstellung der Behälter durch z.B. ein 3-D-Druckverfahren ermöglicht hierbei die exakte Anordnung der Austrittsöffnungen zwischen den Wafern bzw. Halbleiterwerkstücken.

Dies erlaubt außerdem einen besseren bzw. optimierten Wechsel der Medien bzw. Chemikalien im Prozessbehälter. Durch Integration der Zu- bzw. Abführungen in die Behälterform sind keine Rohrleitungen in den Behältern erforderlich und dadurch wird vermieden, dass bei Medienwechsel in den Behältern, z.B. von Ätzlösungen auf Spülflüssigkeit, Medienreste den Folgeschritt negativ beeinflussen und zu Beschädigungen, z.B. Verätzungen an den Oberflächen der Halbleiterwerkstücke, beitragen.

Eine integrierte und frei gestaltbare Zu- bzw. Abführung erlaubt insbesondere für Chemikalien die Gestaltung von Ablauf - und Überlauföffnungen für einen verbesserten bzw. optimierten Abtransport von Verunreinigungen und schnellen Wechsel der Flüssigkeitsmenge. Das additive Aufbauverfahren bzw. der 3-D-Druck bei einem Prozessbehälter ermöglicht die örtlich möglichst optimale Anordnung von Zu- bzw. Abführungen auch für sonstige Medium innerhalb des Prozessbehälters, sodass speziell in Reinigungssystemen für z.B. Silizium-Wafer Partikel (die typische Größen im Nanometer- und Mikrometerbereich aufweisen) gezielt von Wafer-Oberflächen abgespült, abgesprüht und bei gefülltem Prozessbehälter durch gerichtete Flüssigkeitsströme an den der Flüssigkeit ausgesetzten Oberflächen von den Wafern entfernt werden können, und zwar ohne die Notwendigkeit von Einbaukomponenten wie z.B. Rohrleitungen, die Flüssigkeitsströme behindern würden.

Möglichst perfekte Fluid- und Strömungseigenschaften können durch eine gewünschte Geometrie mit integrierter Chemikalienzuführung, optimierter Über-bzw. Ablaufposition sowie integrierter Strömungskanäle erreicht werden. Oftmals werden Medien in den Prozessbehältern von Reinigungs- und Ätzanlagen gezielt zu- und abgeleitet, damit in der Zirkulation Partikel und andere Verunreinigungen durch Filter oder andere Verfahren entfernt werden können. In einem Prozessbehälter, der mit dem vorgeschlagenen Verfahren optimiert angefertigt wurde, können Flüssigkeitsströme den chemischen und physikalischen Anforderungen - typischerweise zur Vermeidung von Konzentrationsschwankungen am sog. "Point of Use" (d.h. an dem Ort, wo die Wirkung eintreten soll) und zur Vermeidung einer erneuten Anhaftung von Partikeln nach der Entfernung von Oberflächen - besser angepasst werden.

Dadurch können erforderliche Chemikalienkonzentrationen an Wafer-Oberflächen oder Oberflächen anderer Halbleiterwerkstücke, z.B. bei Ätzprozessen, möglichst genau kontrolliert werden, da sich bei gezielter Zuführung Konzentrationsschwankungen vermeiden lassen und die zugeführten Chemikalien gleichmäßig und zu gleichen Zeiten die zu prozessierenden Oberflächen der Halbleiterwerkstücke erreichen.

Außerdem wird durch das vorgeschlagene additive Aufbauverfahren eine verbesserte bzw. optimierte Platzierung bzw. Anordnung der Halbleiterwerkstücke, z.B. Wafer, mit definierter Prozessführung ermöglicht, und zwar insbesondere in Bezug auf die prozesstechnisch optimalen Zu- bzw. Abführungen von Chemikalien von den Oberflächen der Halbleiterwerkstücke. Bei herkömmlichen Herstellverfahren der Prozessbehälter hingegen müssten oftmals zusätzliche Wafer- oder Kassettenaufnahmen innerhalb der Behälter eingebaut werden, die die Flüssigkeitsströme in den Behältern behindern.

In Verbindung mit z.B. einer Software zur Prozess-Simulation lassen sich frei wählbare Maßangaben für das 3-D-Druckverfahren generieren, die der Idealform aus der Simulation entsprechen. Bei herkömmlichen Herstellverfahren von (Wafer-)Prozessbehältern lassen sich die idealen Maßangaben aus der Prozess-Simulation hingegen nur bedingt verwenden.

Außerdem führen gezielte Strömungsrichtungen, z. B. mit gewünschter Zirkulation, bei Vermeidung von Verwirbelungen und Turbulenzen, zur optimalen Chemikalienzuführung an die Halbleiterwerkstücke wie z.B. Wafer. Typischerweise werden in Reinigungssystemen Partikel oder andere Verunreinigungen von den Oberflächen der Halbleiterwerkstücke entfernt, aber durch ungünstige Verwirbelungen wieder an die Oberflächen herangeführt und können dort erneut anhaften. Die frei wählbare Formgebung gepaart mit frei wählbaren Zu- und Abführungen für Medien bzw. Chemikalien führt zu einer optimalen Beseitigung der von Oberflächen von Halbleiterwerkstücken entfernten Partikel und anderer Verunreinigungen.

Die Erfindung betrifft außerdem einen Prozessbehälter für Halbleiterwerkstücke, der einen aus einem Grundmaterial mittels eines additiven Aufbauverfahrens hergestellten Behälter mit einer vorgegebenen Form aufweist, wobei zumindest in vorbestimmten Bereichen einer Oberfläche des Behälters ein Beschichtungsmaterial zum Schutz gegen Chemikalien aufgebracht ist. Ein solcher Prozessbehälter ist dabei bevorzugt mittels eines erfindungsgemäßen Verfahrens hergestellt. Hinsichtlich weiter bevorzugter Ausgestaltungen und Vorteile sei zur Vermeidung von Wiederholungen auf vorstehenden Ausführungen zum Verfahren verwiesen, die hier entsprechend gelten.

Zusammenfassend ist nochmals festzuhalten, dass sich mittels eines additiven Aufbau- bzw. Herstellungsverfahrens, z.B. des 3-D-Drucks, annähernd beliebige Formen von Behältern herstellen lassen und damit wesentliche Funktionsmerkmale, z.B. Strömungseigenschaften innerhalb der Flüssigkeiten (also eine fluidtechnische Optimierung) durch Anpassung der Behälterform an die Halbleiterwerkstücke, erzielt werden kann. In Kombination mit chemikalienbeständigen Beschichtungen zumindest der medienberührenden Oberflächen sind diese Behälter als Prozessbehälter für nahezu alle (Wafer-)Prozessanlagen geeignet.

Die Erfindung ermöglicht Prozessbehälter mit geringen Kosten bereits ab dem ersten Stück. Durch ein kleines Volumen des Prozessbehälters werden weniger Verbrauchsstoffe (Wasser, Chemikalien) benötigt. Das additive Aufbauverfahren erlaubt einen geringen Fertigungsaufwand und dadurch schnelle und kostengünstige Optimierungen. Durch planbare Adaptierung an bestehende Systeme gibt es nur geringe Montageaufwände und durch integrierte, mechanische Konstruktionselemente reduziert sich der Materialverbrauch. Die Herstellung bzw. Fertigung des Prozessbehälters ist ohne Spritzguss- oder Tiefziehformen möglich, dadurch ist das Herstellungsverfahren auch für kleine Stückzahlen geeignet. Außerdem ist kein aufwändiges Schweißverfahren nötig. Werkzeuge zum Schweißen, Tiefziehen oder zur spanabhebenden Bearbeitung sind daher nicht erforderlich, wodurch eine Risikominimierung einer metallischen Verunreinigung erreicht wird.

Das additive Aufbauverfahren der Behälter ermöglicht es, diese mit geringeren Wandstärken, dadurch geringerem Gewicht und der Anwendung angepassten mechanischen Eigenschaften fertigen zu können. Die mit herkömmlichen Verfahren gefertigten Behälter werden i.d.R. mehrteilig und mit Rahmen gebaut, wodurch die Herstellverfahren die für die Anwendung erforderlichen, chemischen und mechanischen Eigenschaften mitunter deutlich beschränken.

Weiterhin ist eine perfekte Abstimmung auf Anforderungen während Transporten und/oder Prozessen möglich. Durch die integrierten Werkstückaufnahmen (z.B. für Träger oder "Wafer-Carrier"), die insbesondere auch bei einem Prozessbehälter verschiedenartig ausgebildet sein können, ermöglichen z.B. die Aufnahme von ggf. auch unterschiedlichen Wafer-Kassetten oder sonstiger Träger, z.B. sog. "open cassettes". Die Formgebung lässt sich bei 3-D-gedruckten Behältern den speziellen Anforderungen, z.B. für Nass-Transporte von Silizium-Wafer, anpassen bzw. optimieren. Durch die frei wählbare Formgebung der Behälter lassen sich im Unterschied zu herkömmlichen Herstellverfahren die oftmals unterschiedlichen, prozesstechnischen Anforderungen, wie z.B. Vermeidung von Partikeln und mechanischer Beschädigungen während der Transporte und herausschwappender Flüssigkeiten, besser realisieren.

Weitere Vorteile und Ausgestaltungen der Erfindung ergeben sich aus der Beschreibung und der beiliegenden Zeichnung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispiels in der Zeichnung schematisch dargestellt und wird im Folgenden unter Bezugnahme auf die Zeichnung beschrieben.

### Figurenbeschreibung

- **Figur 1**: zeigt schematisch einen Ablauf eines erfindungsgemäßen Verfahrens in einer bevorzugten Ausführungsform.
- **Figur 2**: zeigt schematisch einen erfindungsgemäßen Prozessbehälter in einer bevorzugten Ausführungsform.

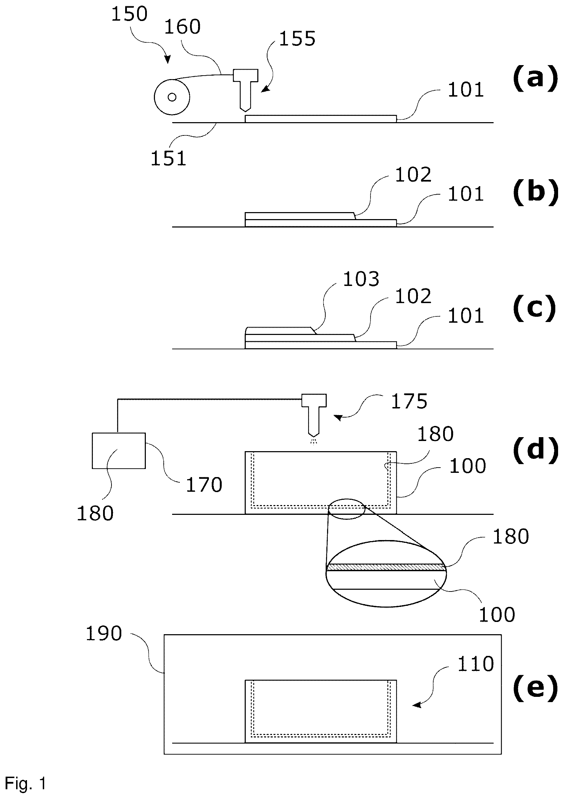

In **Figur 1** ist schematisch ein Ablauf eines erfindungsgemäßen Verfahrens in einer bevorzugten Ausführungsform dargestellt. Hierzu ist zunächst in Abbildung (a) grob schematisch eine Vorrichtung 150 für additives Aufbauverfahren, z.B. ein 3-D-Drucker, dargestellt, die einen Druckkopf 155 aufweist, dem ein Grundmaterial 160 zugeführt wird. Mittels des Druckkopfes 155 wird dann zunächst eine erste Schicht 101 des herzustellenden Behälters auf einen Träger 151 aufgebracht.

Im weiteren Verlauf werden weitere Schichten aufgebracht, und zwar indem jeweils eine neue Schicht auf die jeweils vorhergehende Schicht aufgebracht wird. Beispielhaft sind in Abbildung (b) eine weitere Schicht 102, die auf die Schicht 101 aufgebracht wird, und in Abbildung (c) eine weitere Schicht 103, die auf die Schicht 102 aufgebracht wird, gezeigt.

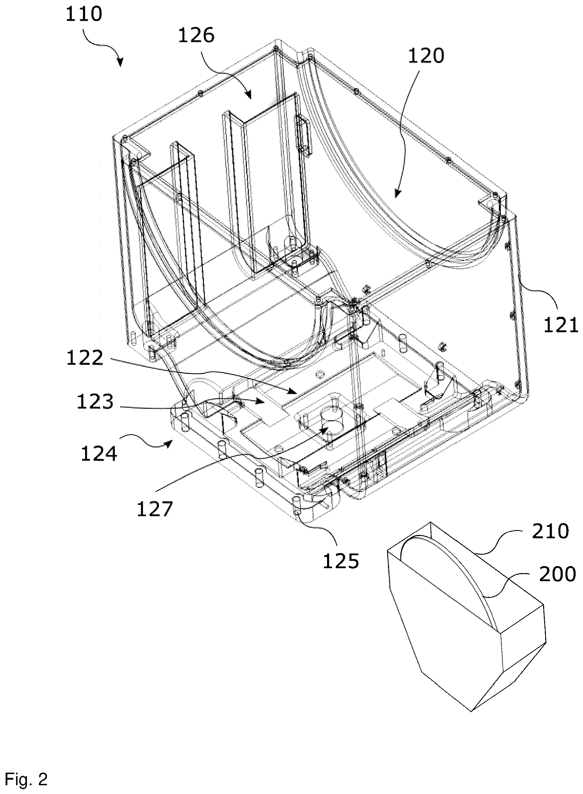

Auf diese Weise wird der Behälter 100 aus dem Grundmaterial mittels eines additiven Aufbauverfahrens in einer gewünschten bzw. vorgegebenen Form hergestellt, wie er grob schematisch in Abbildung (d) gezeigt ist. Für eine detailliertere Ansicht sei an dieser Stelle auf **Figur 2** verwiesen. Wie ebenfalls in Abbildung (d) gezeigt, wird z.B. auf die innenliegenden Oberflächen des - oben offenen - Behälters 100 ein Beschichtungsmaterial 180 aufgebracht, beispielsweise mittels eines Auftragungswerkzeuges 175, dem das Beschichtungsmaterial 180 aus einem Tank 170 zugeführt wird.

Der auf diese Weise beschichtete Behälter 100 wird dann z.B. in einem Ofen 190, wie in Abbildung (e) gezeigt, für eine vorbestimmte Zeitdauer innerhalb eines vorbestimmten Temperaturbereichs, der unterhalb einer Formbeständigkeitstemperatur des Grundmaterials 160 liegt, z.B. bei 150°C, getrocknet, insbesondere gesintert. Auf diese Weise entsteht der fertige Prozessbehälter 110, der damit auch chemikalienbeständig ist.

In **Figur 2** ist schematisch ein erfindungsgemäßer Prozessbehälter 110 in einer bevorzugten Ausführungsform dargestellt, wie er beispielsweise mittels des in **Figur 1** gezeigten und in Bezug darauf beschriebenen Verfahrens hergestellt werden kann. Hierbei ist insbesondere die Form bzw. Formgebung des Prozessbehälters 110 gezeigt, die bereits in Bezug auf **Figur 1** angesprochene Beschichtung mit dem Beschichtungsmaterial ist hier der Übersichtlichkeit halber nicht explizit gezeigt.

Zusätzlich ist - etwas verkleinert - ein Träger bzw. "Wafer-Carrier" 210 mit beispielhaft einem darin eingebrachten, als Silizium-Wafer ausgebildeten Halbleiterwerkstück 200 gezeigt.

Wie schon mehrfach erwähnt, erlaubt das vorgeschlagene, additive Aufbauverfahren eine freie und damit optimierte Gestaltung von z.B. Wafer-Prozess- und/oder Transportbehältern. Es sind keine An- und Einbaukomponenten, die die Prozesse innerhalb der Behälter beeinflussen, nötig, vielmehr kann der Behälter auch schweißnahtfrei und materialsparend aufgebaut werden. Chemikalienzuführungen können an den prozessrelevanten Positionen angeordnet sein, dadurch werden eine exakte Zuführung der reaktiven Chemikalien an die Wafer-Oberflächen und eine Reduzierung von Konzentrationsabnahmen und Turbulenzen innerhalb der Flüssigkeit erlaubt.

Die Bauform lässt sich sehr genau auf ein erforderliches Flüssigkeitsvolumen, typischerweise um eine bestimmte Anzahl von Wafern mit gleichbleibender Chemikalienkonzentration reagieren zu lassen, anpassen und reaktive Chemikalien lassen sich dadurch gegenüber herkömmlichen Beckenformen reduzieren. Wie in **Figur 2** zu sehen, ist die Form des Prozessbehälters an eine bestimmte Anzahl von Wafern angepasst, damit ist auch das Volumen für z.B. darin einzubringende Chemikalien auf ein nötiges Minimum reduziert.

Die Bauform ist fluidtechnisch optimiert, typischerweise für Wafer-Reinigungsanlagen, um dadurch den Abtransport von Partikeln von Wafer-Oberflächen hin zu Abführungsöffnungen ohne erneute Anlagerung der Partikel an Wafer-Oberflächen, zu erreichen. Beispielhaft sind hierfür die halbrunden, seitlichen Vertiefungen 120, die insbesondere Strömungskanäle bilden, im Prozessbehälter 110 gezeigt, die ein möglichst optimales Umströmen darin eingebrachter, runder Wafer ermöglichen.

Am Boden des Prozessbehälters 110 ist eine Zufuhr für Medien bzw. Chemikalien vorgesehen, ebenso ist an der hinteren Seitenwand beispielhaft eine Abführung 126 für Medien bzw. Chemikalien gezeigt, die z.B. in Form eines Überlaufs ausgebildet sein kann. Zudem ist eine Versteifung 121 an einer vorderen, seitlichen Kante des Prozessbehälters 110 gezeigt, die durch das additive Aufbauverfahren direkt in den Behälter integriert werden kann.

Weiterhin ist beispielhaft eine Werkstückaufnahme 122 vorgesehen, die im Rahmen der Herstellung des Prozessbehälters durch entsprechende Formgebung in diesen integriert wird. In diese Werkstückaufnahme 122 kann beispielweise der ebenfalls gezeigte Träger bzw. "Wafer-Carrier" 210 bündig und sicher eingesetzt werden, zusätzliche Einbaukomponenten sind nicht nötig. Je nach Bedarf kann z.B. auch vorgesehen sein, dass in eine solche Werkstückaufnahme auch direkt eines oder mehrere Halbleiterwerkstücke (oder Wafer) - ohne Verwendung eines "Wafer-Carriers" - einsetzbar sind.

Weiterhin sind integrierte Rahmen und Befestigungen (auch im Sinne mechanischer Schnittstellen) für eine einfache Adaption oder Befestigung in Prozessanlagen möglich. Beispielhaft ist ein als Schiene ausgebildeter Rahmen 124 an der Unterseite des Prozessbehälters 110 vorgesehen, in den z.B. mehrere Bohrungen 125 eingebracht sein können, die z.B. zusammen mit geeigneten Schrauben oder Stiften der Fixierung dienen können.

Weiterhin ist beispielhaft eine Sensoraufnahme 123 durch geeignete Formgebung ausgebildet, in die ein Sensor eingebracht werden kann, der z.B. der Überwachung eines bestimmten Prozesses dienen kann.

An dieser Stelle sei noch erwähnt, dass die hier in die Form des Prozessbehälters integrierten Komponenten bzw. Funktion nur beispielhaft sind. Es können auch weitere Komponenten bzw. Funktion vorgesehen sein. Je nach gewünschter Verwendung des Prozessbehälters können auch nur bestimmte Komponenten bzw. Funktionen vorgesehen sein. So benötigt ein reiner Transportbehälter z.B. keine Zu- und Abführungen für Medien, allerdings z.B. eine Werkstückaufnahme.

Der Schutzbereich des europäischen Patents wird durch die Patentansprüche bestimmt.

## Patentansprüche

1. Verfahren zum Herstellen eines Prozessbehälters (110) zur chemischen Behandlung von Halbleiterwerkstücken (200), der aus einem Grundmaterial (160) mittels eines 3D Drucks mit einer vorgegebenen Form erzeugt wird,
wobei anschließend zumindest in vorbestimmten Bereichen einer Oberfläche des Prozessbehälters ein Beschichtungsmaterial (180) zum Schutz gegen Chemikalien, die geeignet sind, das Halbleiterwerkstück zu ätzen, aufgebracht wird,
wobei das Beschichtungsmaterial mittels eines Niedertemperatur-Beschichtungsverfahrens, insbesondere eines Niedertemperatur-Sinterverfahrens, bevorzugt mit einer Temperatur unterhalb von 150°C,
aufgebracht wird,
wobei als Beschichtungsmaterial Polytetrafluorethylen, PTFE, Perfluoralkoxy-Polymer, PFA, oder Polyvinylidenfluorid, PVDF, verwendet wird.

2. Verfahren nach Anspruch 1,
wobei das Beschichtungsmaterial bei dem Niedertemperatur-Beschichtungsverfahren in zumindest den vorbestimmten Bereichen der Oberfläche des Behälters aufgebracht und
anschließend für eine vorbestimmte Zeitdauer innerhalb eines vorbestimmten Temperaturbereichs,
der insbesondere unterhalb einer Formbeständigkeitstemperatur des Grundmaterials liegt,
getrocknet, insbesondere gesintert wird.

3. Verfahren nach einem der vorstehenden Ansprüche,
wobei als Grundmaterial ein Polyamid, insbesondere gefüllt mit Glaskugeln, verwendet wird

4. Verfahren nach einem der vorstehenden Ansprüche,
wobei die vorgegebene Form des Prozessbehälters eine Zu- und/oder eine Abführung für Medien oder Chemikalien aufweist.

5. Verfahren nach einem der vorstehenden Ansprüche,
wobei die vorgegebene Form des Prozessbehälters eine oder mehrere integrierte Werkstückaufnahmen für eines oder mehrere Halbleiterwerkstücke und/oder Träger für Halbleiterwerkstücke aufweist.

6. Verfahren nach einem der vorstehenden Ansprüche,
wobei die vorgegebene Form des Prozessbehälters einen oder mehrere Rahmen und/oder eine oder mehrere Befestigungseinrichtungen zur Anbringung an einer Prozessanlage und/oder eine oder mehrere Versteifungen aufweist.

7. Prozessbehälter (110) zur chemischen Behandlung von Halbleiterwerkstücken (200), der aus einem Grundmaterial (160) mittels eines 3D Drucks hergestellt wurde und eine vorgegebene Form aufweist,
wobei zumindest in vorbestimmten Bereichen einer Oberfläche des Prozessbehälters ein Beschichtungsmaterial (180) zum Schutz gegen Chemikalien, die geeignet sind, das Halbleiterwerkstück zu ätzen, aufgebracht ist, wobei das Beschichtungsmaterial mittels eines Niedertemperatur-Beschichtungsverfahrens, insbesondere eines Niedertemperatur-Sinterverfahrens, bevorzugt mit einer Temperatur unterhalb von 150°C, aufgebracht wird, wobei als Beschichtungsmaterial Polytetrafluorethylen, PTFE, Perfluoralkoxy-Polymer, PFA, oder Polyvinylidenfluorid, PVDF, verwendet wird.

8. Prozessbehälter nach Anspruch 7,
der mittels eines Verfahrens nach einem der Ansprüche 1 bis 6 hergestellt ist.

## Claims

1. Method for manufacturing a process container (110) for the chemical treatment of semiconductor workpieces (200), which is generated with a specified shape from a base material (160) by means of 3D printing,
wherein subsequently a coating material (180) is applied at least in predetermined regions of a surface of the process container for protection against chemicals capable of etching the semiconductor workpiece, the coating material being applied via a low-temperature coating method, more particularly a low-temperature sintering method, preferably with a temperature below 150°C,
wherein polytetrafluoroethylene, PTFE, perfluoroalkoxy polymer, PFA, or polyvinylidene fluoride, PVDF, is used as coating material.

2. Method according to Claim 1,
wherein the coating material in the case of the low-temperature coating method is applied in at least the predetermined regions of the surface of the container and is subsequently dried, more particularly sintered, for a predetermined time period within a predetermined temperature range,
which in particular is below a distortion resistance temperature of the base material.

3. Method according to any of the preceding claims,
wherein a polyamide, more particularly filled with glass beads, is used as base material.

4. Method according to any of the preceding claims, wherein the specified shape of the process container comprises a feed and/or a discharge port for media or chemicals.

5. Method according to any of the preceding claims, wherein the specified shape of the process container comprises one or more integrated workpiece receptacles for one or more semiconductor workpieces and/or carriers for semiconductor workpieces.

6. Method according to any of the preceding claims, wherein the specified shape of the process container comprises one or more frames and/or one or more fastening devices for attachment to a process unit and/or one or more stiffeners.

7. Process container (110) for the chemical treatment of semiconductor workpieces (200), manufactured from a base material (160) by means of 3D printing and having a specified shape, wherein at least predetermined regions of a surface of the process container bear an applied coating material (180) for protection against chemicals capable of etching the semiconductor workpiece, the coating material being applied via a low-temperature coating method, more particularly a low-temperature sintering method, preferably with a temperature below 150°C, wherein polytetrafluoroethylene, PTFE, perfluoroalkoxy polymer, PFA, or polyvinylidene fluoride, PVDF, is used as coating material.

8. Process container according to Claim 7, manufactured via a method according to any of Claims 1 to 6.

## Revendications

1. Procédé de fabrication d'une cuve de traitement (110) pour le traitement chimique de pièces de semi-conducteur (200), qui est produite à partir d'un matériau de base (160) par impression 3D selon une forme prédéfinie,
dans lequel on applique ensuite, au moins dans des zones prédéterminées d'une surface de la cuve de traitement, un matériau de revêtement (180) pour une protection contre les agents chimiques qui conviennent à la gravure de la pièce de semi-conducteur,
dans lequel le matériau de revêtement est appliqué par un procédé de revêtement à basse température, en particulier un procédé de frittage à basse température, de préférence à une température inférieure à 150 °C, dans lequel on utilise comme matériau de revêtement du polytétrafluoréthylène, PTFE, un polymère perfluoralcoxylé, PFA ou du poly(fluorure de vinylidène), PVDF.

2. Procédé selon la revendication 1,
dans lequel le matériau de revêtement est appliqué, dans le procédé de revêtement à basse température, sur au moins les zones prédéfinies de la surface de la cuve et
puis on sèche, en particulier on fritte pendant un temps prédéfini, sur une plage de températures prédéfinie, qui en particulier est inférieure à la stabilité dimensionnelle à chaud du matériau de base.

3. Procédé selon l'une des revendications précédentes, dans lequel on utilise comme matériau de base un polyamide, de préférence chargé de billes de verre.

4. Procédé selon l'une des revendications précédentes,
dans lequel la forme prédéfinie de la cuve de traitement présente un orifice d'arrivée et/ou un orifice d'évacuation destinés à des fluides ou des agents chimiques.

5. Procédé selon l'une des revendications précédentes,
dans lequel la forme prédéfinie de la cuve de traitement présente un ou plusieurs logements de pièce intégrés, pour une ou plusieurs pièces de semi-conducteur et/ou des supports pour des pièces de semi-conducteur.

6. Procédé selon l'une des revendications précédentes,
dans lequel la forme prédéfinie de la cuve de traitement comprend un ou plusieurs cadres et/ou un ou plusieurs dispositifs de fixation, destinés à une mise en place contre une installation de traitement et/ou un ou plusieurs renforcements.

7. Cuve de traitement (110) pour le traitement chimique de pièces de semi-conducteur (200), qui a été fabriquée à partir d'un matériau de base (160) par impression 3D et présente une forme prédéfinie, un matériau de revêtement (180) étant, au moins dans des zones prédéfinies d'une surface de la cuve de traitement, appliqué pour assurer une protection contre les agents chimiques qui conviennent à la gravure de la pièce de semi-conducteur, le matériau de revêtement étant appliqué par un procédé de revêtement à basse température, en particulier un procédé de frittage à basse température, de préférence à une température inférieure à 150 °C, le matériau de revêtement utilisé étant le polytétrafluoréthylène, PTFE, un polymère perfluoralcoxylé, PFA ou du poly(fluorure de vinylidène), PVDF.

8. Cuve de traitement selon la revendication 7, qui a été fabriquée par un procédé selon l'une des revendications 1 à 6.
